# EUROPÄISCHE PATENTSCHRIFT

(11) **EP 0 474 088 B1**
(45) Veröffentlichungstag und Bekanntmachung des Hinweises auf die Patenterteilung: **24.04.1996**
(21) Anmeldenummer: 91114294.1
(22) Anmeldetag: 26.08.1991
(51) Int. Cl.: G01R 15/12

(54) **Messverfahren zum Messen unterschiedlicher Messgrössen und Multimeter zur Durchführung des Verfahrens**
Method for measuring different variables and multimeter for performing same
Procédé pour mesurer des variables différentes et contrôleur universel pour exécuter le procédé

(30) Priorität: 01.09.1990 DE 4027804; 01.09.1990 DE 4027802
(43) Veröffentlichungstag der Anmeldung: 11.03.1992
(73) Patentinhaber: ABB PATENT GmbH, D-68309 Mannheim (DE)
(72) Erfinder: Henkelmann, Dieter, W-8500 Nürnberg 50 (DE)
(74) Vertreter: Rupprecht, Klaus, Dipl.-Ing.

(56) Entgegenhaltungen:
- DE-A- 3 130 786
- US-A- 4 604 569

## Beschreibung

Die Erfindung betrifft ein Meßverfahren und ein Multimeter zur Durchführung des Verfahrens nach dem Oberbegriff des Anspruchs 1.

Meßgeräte, insbesondere Multimeter gehören heute zum üblichen Werkzeug sowohl des Elektrohandwerkers wie auch des Labortechnikers. Andererseits handelt es sich hierbei um relativ teure Werkzeuge, die man so weit wie möglich vor einer Zerstörung geschützt sehen möchte. Die Gefahr, ein Multimeter, das zur Messung sehr unterschiedlicher Meßgrößen geeignet ist, durch Fehlbedienung zu zerstören, ist fast allgegenwärtig.

So passiert es immer wieder, daß ein Meßgerät für eine Strommessung eingestellt wurde, jedoch versehentlich an Netzspannung gelegt wird. In diesem Fall wird zumindest der zur Strommessung ausgelegte Eingangskreis des Multimeters mit seinen Shunts zerstört. Unterbricht die Netzsicherung den Stromkreis nicht schnell genug, so kann auch der Benutzer gefährdet werden, da die im Multimeter vorgesehene Gerätesicherung in aller Regel nicht ausreicht, um das Multimeter von einer energiereichen Spannungsquelle zu trennen. Der beim Öffnen des Stromkreises möglicherweise auftretende Lichtbogen überbrückt die Gerätesicherung, und der sich hierbei entwickelnde Schadensverlauf ist oft nicht vorhersehbar.

Selbstverständlich hat man versucht, mit zusätzlichen Sicherungsmaßnahmen die Gefahren einer Fehlbedienung in Grenzen zu halten. Die verwendeten Schutzschaltungen arbeiten mit passiven und aktiven Schaltern und Relaisschaltern, gesteuerten Halbleiterschaltern, mit Transistoren und Thyristoren sowie Schmelzsicherungen besonderer Bauart. Trotz des teilweise recht hohen Aufwandes gelingt es mit bisherigen Techniken jedoch keineswegs immer, leistungsstarke Spannungsquellen innerhalb des kleinen, bei modernen Multimetern zur Verfügung stehenden Raumes im Fehlerfall sicher abzuschalten. Ein besonderes Problem stellen die hohen Ströme dar, die im Fehlerfall den Eingangskreis des Meßgerätes durchfließen und zum Schutz des Eingangskreises nunmehr abgeschaltet werden müssen.

Aufgabe der Erfindung ist es, ein Verfahren und ein Multimeter zur Durchführung dieses Verfahrens zu schaffen, mit dem es gelingt, ungeeignete, bestimmte Eingangskreise des Meßgerätes gefährdende Meßgrößen von diesen Eingangskreisen grundsätzlich fernzuhalten, so daß ein Abschalten des Eingangskreises nicht erforderlich ist und auch bei Fehlbedienung kein Schaden am Multimeter entstehen kann.

Diese Aufgabe wird durch die in den Ansprüchen 1 und 5 gekennzeichneten Merkmale gelöst. Zweckmäßige Ausgestaltungen und Weiterbildungen der Erfindung sind in den Unteransprüchen genannt.

Die Lösung der gestellten Aufgabe bietet dem Multimeter einen präventiven Schutz, derart, daß bei einer falsch vorgegebenen Meßgröße, der dieser Meßgröße zugeordnete Eingangskreis, sofern es sich um einen gefährdeten Eingangskreis, also z.B. einen Eingangskreis zur Messung eines Stromes handelt, gar nicht erst mit dem gefährlichen Meßsignal verbunden wird, und damit das kritische Abschalten, das üblicherweise bei bekannten Schutzschaltungen praktiziert wird, entfällt.

Wegen seines hohen Eingangswiderstandes nicht gefährdet ist der Eingangskreis zur Spannungsmessung. Mit diesem Eingangskreis kann jede beliebige Meßgröße verbunden werden, ohne daß das Meßgerät hierdurch in Gefahr gerät. In einer Weiterbildung der Erfindung ist deshalb vorgesehen, daß bei Beginn einer Messung unabhängig von der vorgegebenen Meßgröße ein zur Spannungsmessung dienender Eingangskreis mit dem Meßobjekt verbunden wird. Durch eine sich anschließende Spannungsmessung kann nunmehr festgestellt werden, ob das Meßobjekt eine Spannung abgibt. Soll entsprechend der vorgegebenen Meßgröße eine Spannungsmessung erfolgen, so kann hier der Meßablauf bereits abgebrochen werden. Auch dann, wenn die Meßgröße ein Widerstand sein soll, genügt bereits diese erste Spannungsmessung für die Entscheidung, ob der Eingangskreis zur Widerstandsmessung eingeschaltet werden kann. Bei einem Strom als vorgegebene Meßgröße müssen demgegenüber zwei aufeinanderfolgende Spannungsmessungen durchgeführt werden, was im folgenden noch erläutert wird, bevor die Entscheidung zur Freigabe des Eingangskreises für die Strommessung erfolgen kann. Ergibt sich aufgrund der zur Prüfung vorgesehenen Spannungsmessungen, daß das vom Meßobjekt abgegebene Meßsignal mit dem vorgegebenen Eingangskreis nicht gemessen werden kann oder sollte, so erzeugt das Multimeter ein Fehlersignal. Wurde jedoch der richtige Eingangskreis gewählt, so erfolgt nunmehr dessen Freigabe, so daß sich eine Messung der zu untersuchenden Meßgröße anschließen kann.

Wenn bei der Bedienung eines Multimeters ein Spannungsmeßbereich eingeschaltet wird, insbesondere einer für große Spannungen, so besteht keine Gefahr, daß beim Anschluß eines falschen Meßsignals das Multimeter zerstört wird. Die der eigentlichen Messung vorgeschaltete Prüfung des Meßsignals kann somit auf solche Eingangskreise beschränkt werden, die einer Gefährdung ausgesetzt sind, also vorzugsweise Eingangskreise für die Strom- und Widerstandsmessung.

In zweckmäßiger Ausbildung des Erfindungsgegenstandes kann man die Freigabe eines Eingangskreises zur Widerstandsmessung davon abhängig machen, ob bei der vorausgegangenen Spannungsmessung eine Spannung ermittelt wurde bzw. diese Spannung so hoch war, daß sie zu einer Verfälschung des Meßergebnisses oder einer Gefährdung des Meßkreises führen kann.

Ein zur Strommessung geeigneter Eingangskreis kann dann freigegeben werden, wenn ein aus der Leerlauf spannung und dem Innenwiderstand des Meßobjektes ermittelter Kurzschlußstrom für den eingestellten Strommeßbereich keine Gefahr bedeutet. Die Leerlaufspannung des Meßobjektes kann bereits bei seiner ersten Prüfung auf Vorliegen einer Spannung gemessen werden. Den Innenwiderstand des Meßobjektes kann man nach dem Spannungsabsenkungsverfahren ermitteln, wobei nach Messung der Leerlaufspannung eine Belastung des Meßobjektes durch einen Lastwiderstand erfolgt, und die nunmehr am Meßobjekt anliegende verminderte Spannung ebenfalls gemessen wird. Aus der Leerlaufspannung, der Lastspannung und dem Lastwiderstand kann der Innenwiderstand des Meßobjektes berechnet werden.

Die Freigabe eines gefährdeten Eingangskreises sollte sofort aufgehoben werden, sobald das Meßsignal entfällt, da im Normalfall davon auszugehen ist, daß nun ein neues Neßobjekt mit dem Meßgerät verbunden wird, das auch einer erneuten Vorprüfung unterzogen werden muß. Als Kriterium für das Einleiten einer erneuten Vorprüfung kann der Wegfall des Meßsignals oder der plötzliche Anstieg des Eingangswiderstandes beim Trennen der Meßleitung vom Meßobjekt dienen.

In Sonderfällen jedoch, wenn z.B. ein Meßobjekt überwacht werden muß, dessen Meßsignal bis auf Null zurückgehen kann, oder wenn z.B. eine größere Zahl von einzelnen Widerständen geprüft werden soll, sollte es möglich sein, die Rückschaltung auf die Prüfprozedur zu verhindern, um den gegebenenfalls bei etwas langsamen Meßgeräten anfallenden Zeitverlust für die Vorprüfung zu vermeiden.

Ein zur Durchführung des Verfahrens benötigtes Multimeter ermöglicht die Vorgabe der aufzunehmenden Meßgröße durch einen Meßbereichsschalter und/oder verschiedene Eingangsanschlüsse. Den verschiedenen Meßgrößen sind dabei unterschiedliche Eingangskreise zugeordnet. Erfindungsgemäß muß dieses Multimeter so aufgebaut sein, daß mindestens ein Eingangskreisschalter vorgesehen ist, der in Ruhestellung mindestens einen Eingangskreis hat und dieser zur Messung nur eingeschaltet wird, wenn eine Vorprüfung des Meßsignals ergeben hat, daß der einzuschaltende Eingangskreis zur Aufnahme des vom Meßobjekt abgenommenen Meßsignals geeignet ist.

In einer Weiterbildung des Erfindungsgegenstandes kann das Multimeter so aufgebaut werden, daß die Vorprüfung des Meßsignals mit dem selben Meßsystem erfolgt, das zur eigentlichen Hauptmessung dient. Der Eingangskreisschalter muß dann so beschaffen sein, daß er bei einem Wechsel von der Vorprüfung zur Hauptmessung verschiedene Eingangskreise an das Meßsystem anschließen kann. Alternativ hierzu ist es möglich, die Vorprüfung des Meßsignals mit einem eigenen Prüfsystem durchzuführen, das das Eingangssignal unmittelbar hinter den Eingangsanschlüssen abnimmt und somit unabhängig vom jeweils eingeschalteten Eingangskreis immer mit den Eingangsanschlüssen verbunden bleiben kann. Das Prüfsystem kann hierbei relativ einfach aufgebaut werden, da die zu fordernde Meßgenauigkeit sehr gering ist, während andererseits die Zahl der benötigten Schalter für die Eingangskreise reduziert werden kann.

Bei der Prüfung, ob der vorgegebene Eingangskreis für das angelegte Meßsignal geeignet ist, sind zwei unterschiedliche Dinge zu prüfen. So ist zunächst einmal festzustellen, ob die durch den Meßbereichsschalter vorgegebene Meßgröße zu dem vorgegebenen Eingangskreis paßt, wobei der Eingangskreis entweder durch eine Auswahl zwischen verschiededen Eingangsanschlüssen oder durch einen Eingangskreisschalter vorgegeben werden kann. Doch selbst wenn die diesbezügliche Bedienung des Multimeters richtig war, könnte dem Multimeter über seine Meßleitungen noch ein Meßsignal zugeführt werden, das für den vorgesehenen Eingangskreis nicht geeignet ist, so daß diesbezüglich eine zweite Prüfung vorgenommen werden muß, von der die Freigabe des Eingangskreises für das anliegende Meßsignal abhängt.

Eine Möglichkeit den ersten Teil der Prüfung einzusparen besteht darin, mit dem Meßbereichsschalter eine elektrisch und/oder mechanisch wirkende Sperrvorrichtung so zu koppeln, daß eine Kontaktierung nur jeweils des Eingangskreises ermöglicht ist, dessen Meßgröße der mit dem Meßbereichsschalter eingestellten Meßgröße entspricht. Die Vorprüfung kann sich dann auf den zweiten Teil der Prüfung beschränken.

Zweckmäßigerweise erfolgt die Steuerung der Eingangskreisschalter durch eine Eingangskreissteuereinheit, wobei diese wiederum in Abhängigkeit von einer Steuerschaltung aktiviert wird. Die Steuerschaltung gibt den Aktivierungsbefehl nach Prüfung des Meßsignals durch eine Prüfschaltung.

Das Fehlersignal, das bei einem für den vorgesehenen Eingangskreis nicht geeigneten Meßsignal erzeugt wird, kann entweder, z. B. durch einen akustischen Signalgeber, für den Bediener erkennbar gemacht werden und dadurch diesen zum Umschalten des Eingangskreises bewegen oder auch eine automatische Umschaltung des Eingangskreisschalters auf einen geeigneten Eingangskreis bewirken.

Weiterhin ist das Multimeter mit einem Lastwiderstand ausgerüstet, der zur Ermittlung des Innenwiderstandes des Meßobjektes bei bestimmten Meßgrößen, insbesondere vor einer Strommessung, den zugehörigen Eingangskreis mit einem in Reihe liegenden Lastkreisschalter überbrükken kann. Eine Steuerung des Lastkreisschalters erfolgt mit Hilfe der Steuerschaltung auf eine solche Weise, daß mittels der Prüfschaltung die Spannungsabsenkung ermittelt und daraus der Innenwiderstand berechnet werden kann.

Damit der Meßbereichsschalter nicht während einer Messung versehentlich auf eine andere Meßgröße umgeschaltet werden kann, ist es zweckmäßig, diesen mit Hilfe der Steuerschaltung, gegebenenfalls über einen Magnetsteller, solange zu arretieren, solange ein vom Meßobjekt ausgehendes Meßsignal von der Prüfschaltung erfaßt wird. Die Arretierung kann dabei so ausgebildet sein, daß nur das Umschalten auf eine andere Meßgröße nicht aber auf einen anderen Meßbereich derselben Meßgröße gesperrt wird. Ein Umschalten auf eine andere Meßgröße ist somit nur möglich, wenn alle Eingangskreise stromlos sind.

Da an die Leistungsfähigkeit der Steuerschaltung relativ hohe Anforderungen zu stellen sind, ist es zweckmäßig, diese mit Hilfe eines oder mehrerer Mikroprozessoren aufzubauen, die dann bei Bedarf auch weitere Steuer- und Rechenfunktionen wahrnehmen können. Darüberhinaus ist es möglich, die Prüfschaltung und die Eingangskreissteuereinheit in die Steuerschaltung zu integrieren und über einen Handsteller eine Programmierung oder Eingabe bestimmter Anweisungen vornehmen zu können.

Ausführungsbeispiele der Erfindung sind in den Zeichnungen dargestellt und werden im folgenden näher beschrieben.

Es zeigen:
- Fig. 1: Ein Blockschaltbild eines Multimeters zur Vorprüfung des Meßsignals,
- Fig. 2: ein Prinzipschaltbild zur Sperrung bestimmter Eingangskreise bei einem Multimeter mit zwei gemeinsamen Eingagsanschlüssen,
- Fig. 3: ein Meßbereichsschalter und ein handbetätigter Eingangskreisschalter in Draufsicht auf die Deckplatte des Multimeters,
- Fig. 4: eine mechanische Kopplung zwischen dem Meßbereichs- und dem Eingangskreisschalter nach Figur 3 in Draufsicht,
- Fig. 5: eine mechanische Kopplung zwischen Meßbereichs- und Eingangskreisschalter in Seitenansicht in entkoppelter Stellung,
- Fig. 6: eine mechanische Kopplung zwischen Meßbereichs- und Eingangskreisschalter in Seitenansicht in gekoppelter Stellung und
- Fig. 7: Ein Ablaufdiagramm für die Vorprüfung bei einer Strommessung.

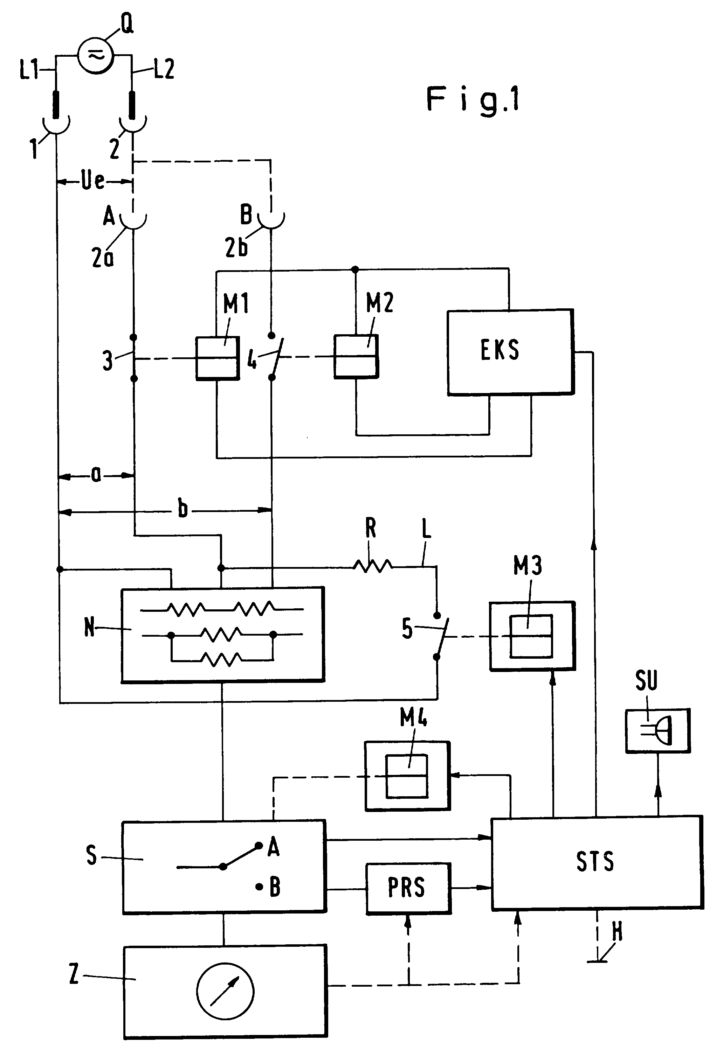

Wie in Figur 1 dargestellt, besteht im Prinzip die Möglichkeit, die zu ermittelnde Meßgröße A oder B durch einen Meßbereichsschalter S oder durch mehrere Eingangsbuchsen 2a,2b vorzugeben. Bei mehreren Eingangsanschlüssen 2a,2b wäre es erforderlich, bei einem Wechsel der Meßgröße mindestens eine der Meßleitungen L1,L2 umzustecken, was bei einem komfortablen Gerät unerwünscht ist. Die diese Möglichkeit andeutende gestrichelte Leitung, die die Eingangsanschlüsse 2a,2b miteinander verbindet, kann somit für die weitere Beschreibung als feste Verbindung betrachtet werden.

Das Multimeter besitzt somit die Eingangsanschlüsse 1 und 2, mit denen über Meßleitungen L1,L2 ein Meßobjekt Q verbunden ist. Zu messen ist das vom Meßobjekt abgegebene oder an diesem erzeugte Meßsignal Ue. Je nach Art der Meßgröße gelangt das Meßsignal Ue über den Eingangskreis a, der der Meßgröße A zugeordnet ist, oder über den Eingangskreis b, der der Meßgröße B zugeordnet ist, zu einem entsprechenden Meßbereichsnetzwerk N, das mit Hilfe eines Meßbereichsschalter S umgeschaltet wird. Zur Auswertung und Anzeige des Meßsignals Ue dient ein dem Meßbereichsschalter S nachgeschaltetes Meßsystem Z.

Die weiteren Baugruppen des Blockschaltbildes dienen zur Realisierung der der eigentlichen Messung vorgeschalteten Prüfphase. Eine Steuerschaltung STS sorgt über eine Eingangskreissteuereinheit EKS dafür, daß in der Prüfphase unabhängig von der vorgegebenen Stellung des Meßbereichsschalters S der zur Spannungsmessung dienende Eingangskreis a,b, also z.B. der Eingangskreis a eingeschaltet wird, während alle übrigen Eingangskreise geöffnet bleiben. Die Prüfschaltung PRS vergleicht nun die Stellung des Meßbereichsschalters S mit der Art des aufgenommenen Meßsignals Ue und entscheidet nach geeigneten Kriterien, ob der Eingangskreis a wieder zu öffnen ist und dafür ein anderer der Stellung des Meßbereichsschalters entsprechender Eingangskreis, z.B. b eingeschaltet werden kann. Wurde am Meßbereichsschalter S eine Spannung als Meßgröße vorgegeben, so erfolgt keine Umschaltung und der im Eingangskreis a liegende Eingangskreisschalter 3 bleibt eingeschaltet.

Soll beispielsweise ein Widerstand gemessen werden, für dessen Messung der Eingangskreis b ausgelegt sei, so wird die Prüfschaltung PRS, vorausgesetzt auch durch den Meßbereichsschalter wurde ein Widerstand z.B. als Meßgröße b vorgegeben, bei fehlenden Eingangssignal Ue über die Steuerschaltung STS und die Eingangskreissteuereinheit EKS zunächst das Öffnen des ersten Eingangskreisschalters 3 und dann das Schließen des zweiten Eingangskreisschalters 4 auslösen. Stellt die Prüfschaltung PRS jedoch fest, daß eine bedenkliche Spannung als Meßsignal Ue an den Eingangsanschlüssen 1,2 anliegt, die zu einer Gefährdung oder zumindest Verfälschung des Meßergebnisses führen könnte, so bleibt der erste Eingangskreisschalter 3 geschlossen, der zweite Eingangskreisschalter 4 geöffnet und es wird ein akustischer Signalgeber, z.B. ein Summer SU, zur Abgabe eines Fehlersignals aktiviert. Der Bedienende wird dadurch veranlaßt den Meßbereichsschalter S in die dem Meßsignal entsprechende Schaltstellung zu bringen.

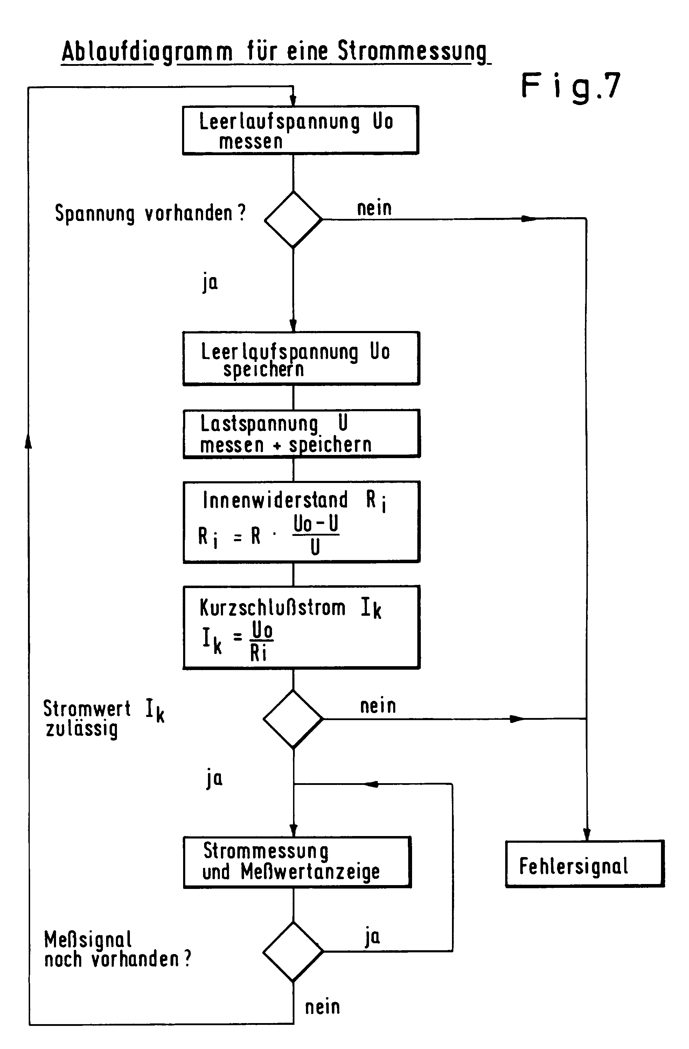

Geht man davon aus, daß über den Meßbereichsschalter S ein Strom als Meßgröße b vorgegeben ist, so läuft das Meßverfahren nach dem in Fig. 7 dargestellten Ablaufdiagramm ab. Nach einem Initialisieren, z.B. Einschalten des Multimeters, läuft das Meßverfahren automatisch ab. Zunächst sorgt die Steuerschaltung STS wieder dafür, daß nur der Eingangskreisschalter 3 eingeschaltet wird, und damit den Eingangskreis a zu der durch die Meßgröße A repräsentierten Spannungsmessung freigibt. Sollte die Prüfschaltung PRS keine Spannung feststellen können, so teilt sie dieses Ergebnis der Steuerschaltung STS mit, die durch den akustischen Signalgeber SU für ein Fehlersignal sorgt, das dem Benutzer signalisiert, daß das angeschlossene Meßobjekt Q für eine Strommessung nicht geeignet ist. Gibt das Meßobjekt Q jedoch eine Spannung ab, so wird diese Spannung als Leerlaufspannung Uo gespeichert und durch die Steuerschaltung STS über einen Magnetschalter M3 und einen Lastkreisschalter 5 ein Lastkreis L mit einem Widerstand R mit dem Meßobjekt Q verbunden. Die gegenüber der Leerlaufspannung Uo durch die Belastung nunmehr verminderte Lastspannung U wird ebenfalls gemessen und gespeichert. Mit Hilfe der beiden gemessenen Spannungswerte Uo,U und d bekannten Wert R des Widerstandes im Lastkreis L kann die Prüfschaltung PRS zunächst den Innenwiderstand Ri und mit dessen Hilfe und der Leerlaufspannung Uo den Kurzschlußstrom Ik berechnen. Die Prüfschaltung PRS stellt nun fest, ob der ermittelte Stromwert noch als zulässig betrachtet werden kann oder ob z.B. aus Versehen eine Spannungsquelle und nicht wie beabsichtigt, eine Stromquelle als Meßobjekt Q an die Eingangsanschlüsse 1,2 angeschlossen wurde. Sollte der Stromwert den zulässigen Bereich überschreiten, so gibt die Prüfschaltung diese Information wiederum an die Steuerschaltung weiter, die ihrerseits durch den Signalgeber SU ein Fehlersignal auslöst. Liegt dagegen der Kurzschlußstrom Ik in einem zur Strommessung mit dem Multimeter zulässigen Bereich, so aktiviert die Steuerschaltung STS die Eingangskreissteuereinheit EKS und diese sorgt dafür, daß zunächst der Eingangskreis a durch Öffnen des Eingangskreisschalters 3 unterbrochen wird und dann der Eingangskreis b durch Schließen des zweiten Eingangskreisschalters 4 zur Strommessung freigegeben wird. Es erfolgt nun die beabsichtigte Strommessung. Diese wird solange fortgesetzt, bis sich der Eingangskreis öffnet, z.B. weil das Meßobjekt Q entfernt wird, um ein anderes Meßobjekt zu untersuchen.

Damit es durch versehentliches Umschalten des Meßbereichsschalters S auf eine andere Meßgröße a,b nicht zu Meßfehlern kommt, sorgt die Steuerschaltung STS über einen Magnetsteller M4 für eine Arretierung des Meßbereichsschalters S, die solange aufrechterhalten wird, bis das Meßsignal wegfällt. Die Arretierung blockiert selbstverständlich nur ein Umschalten zwischen verschiedenen Meßgrößen, nicht jedoch zwischen verschiedenen Meßbereichen derselben Meßgröße.

Multimeter mit elektronischer Ausstattung benötigen eine Batterie zur Stromversorgung, deren Kapazität geschont werden muß, um die Zeitabstände für einen Batteriewechsel möglichst groß zu halten. Es gilt somit, Bauelemente mit erhöhtem Stromverbrauch möglichst zu vermeiden. Während Halbleiter heute nur noch einen sehr geringen Versorgungsstrom benötigen, kann das von Magnetschaltern nicht ohne weiteres behauptet werden. Dies gilt selbst dann, wenn mit bistabilen Magnetschaltern gearbeitet wird, zu deren Umschaltung es nur eines Impulses bedarf also kein Haltestrom benötigt wird. Es wäre somit von Vorteil die in der Schaltung nach Figur 1 verwendeten Magnetschalter einerseits durch handbetätigte Schalter zu ersetzen, als hierdurch keine bedeutsamen Einbußen bezüglich des Bedienungskomforts hingenommen werden müssen.

Bei der erfindungsgemäß der eigentlichen Messung vorgeschalteten Vorprüfung des Meßsignals muß zwischen zwei Arten einer Fehlbedienung unterschieden werden. So ist es bei herkömmlichen Multimetern zunächst einmal möglich, den Meßbereichsschalter auf eine nicht mit dem Eingangskreis übereinstimmende Meßgröße einzustellen. Doch auch wenn die richtige Vorgabe der Meßgröße sichergestellt ist, verbleibt die Möglichkeit ein hiermit nicht übereinstimmendes Meßsignal z. B. durch Anschließen eines falschen Meßobjektes, an den Eingang des Multimeters zu legen.

Die Schaltung nach Figur 1 unterscheidet nicht zwischen diesen beiden Fehlervarianten, da die durch sie vorgenommene Prüfung grundsätzlich klärt, ob ein anliegendes Meßsignal zur Messung durch den vorgegebenen Eingangskreis geeignet ist und diesen, zumindest wenn es ein gefährdeter Eingangskreis ist, erst dann zur eigentlichen Messung einschaltet. Die Umschaltung der Eingangskreisschalter 4, 5 erfolgt hier automatisch mit Hilfe der Magnetschalter M1, M2, kann aber auch von Hand vorgenommen werden, nachdem die Prüfschaltung PRS, z. B. durch ein für den Bedienenden erkennbares Signal, einen bestimmten Eingangskreis freigegeben hat.

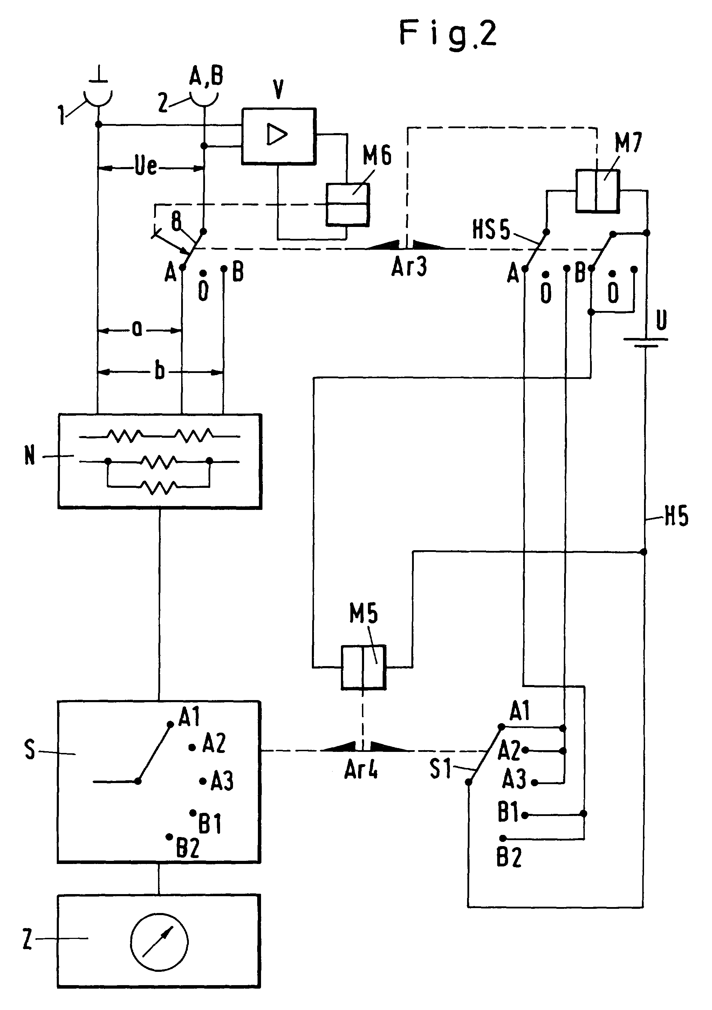

Soweit die Prüfschaltung PRS bei der Überprüfung des Meßsignals auf die durch das Meßbereichsnetzwerk N, den Meßbereichsschalters S und das Meßsystem Z vorgenommene Meßsignalverarbeitung zurückgreift, ist sie, wie in Figur 1 dargestellt, anzuordnen. Die Prüfschaltung PRS könnte jedoch auch mit einem autonomen Meßsystem ausgestattet werden und können dann das Meßsignal unmittelbar hinter den Eingangsanschlüssen 1, 2 abnehmen, wie das bei Figur 2 durch den Verstärker V dargestellt ist.

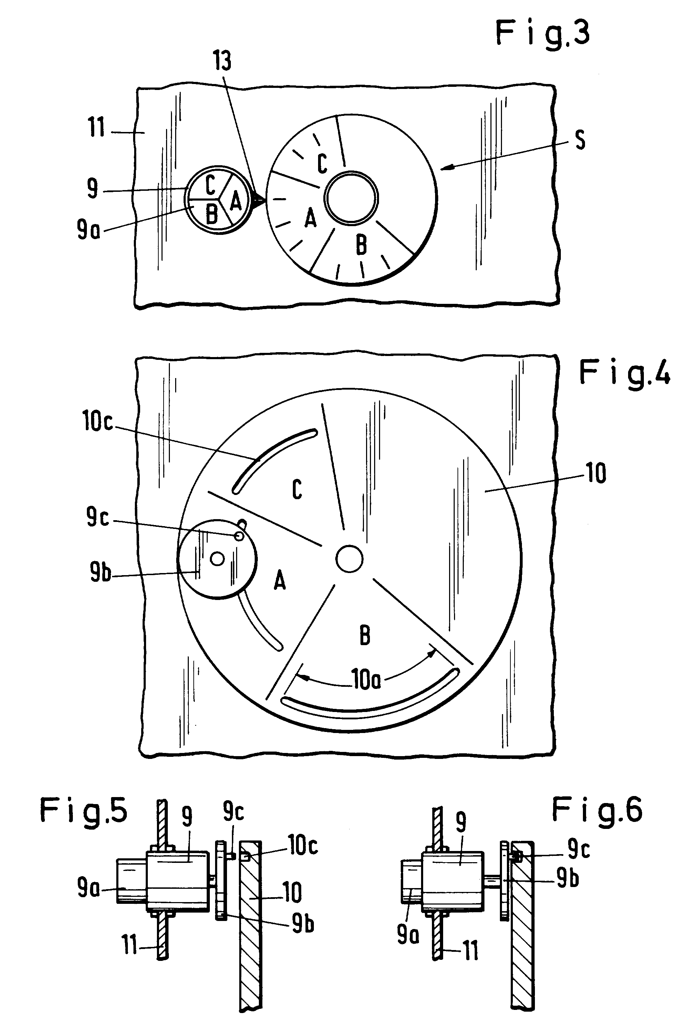

Die Schaltung nach Figur 2 sowie die Darstellungen in den Figuren 3 bis 6 zeigen elektromechanische und rein mechanische Methoden, um sicherzustellen, daß bei zwei getrennt bedienbaren Schaltern, von denen ein erster als Eingangskreisschalter 8, 9 und ein zweiter als Meßbereichsschalter 5 dient, eine Kopplung erfolgen kann, die dafür sorgt, daß sich der jeweilige Eingangskreis a, b nur einschalten läßt, wenn seine Meßgröße mit der durch den Meßbereichsschalter S vorgegebene Meßgröße übereinstimmt. Auf diese Weise kann bereits der erste Teil möglicher Fehlbedienungen ausgeschlossen werden, so daß nur noch geprüft werden muß, ob das Meßsignal zu der am Meßbereichsschalter eingestellten Meßgröße paßt.

Die rein mechanische Kopplung zwischen einem Meßbereichsschalter S und einem Eingangskreisschalter 9 ist in den Figuren 3 bis 6 dargestellt. Wie Fig. 3 zeigt sind die beiden Schalter in unmittelbarer räumlicher Nähe zueinander angeordnet und zwar derart, daß die auf ihrem Bedienknopf aufgebrachte Beschriftung für die Meßgrößen A bis C in eine zueinander korrespondierende Stellung gebracht werden kann. Als Bezugsmarke dient ein zwischen den beiden Bedienknöpfen auf der Deckplatte 11 des Multimeters aufgebrachter Pfeil 13. Beide Bedienknöpfe sind somit in eine Schalterstellung zu bringen, in der der Pfeil 13 auf die gleiche Meßgröße weist. Im vorliegenden Beispiel sind beide Schalter auf die Meßgröße A eingestellt. Beim Meßbereichsschalter S sind den drei Meßgrößen A bis C noch jeweils mehrere Meßbereiche zugeordnet. Die Kopplung zwischen den beiden Schaltern soll so wirken, daß der Eingangskreisschalter nur eingeschaltet werden kann, wenn der Pfeil 13 bei beiden Schaltern auf die gleiche Meßgröße weist. Ein Umschalten des Meßbereichsschalters S zwischen verschiedenen Meßbereichen der gleichen Meßgröße A/B oder C soll jedoch trotz Arretierung möglich sein.

Die Fig. 4 bis 6 verdeutlichen eine Möglichkeit zur Realisierung der Kopplung. Ein zum Meßbereichsschalter S gehöriges und von diesem angetriebenes radartiges Schalterelement 10 ist mit einem so großen Durchmesser versehen, daß es bis in den Aktionsbereich des Eingangskreisschalters 9 reicht. Der Eingangskreisschalter 9 ist als Dreh-Druck-Schalter aufgebaut, der ein Dreh-Druckelement 9a besitzt, das zunächst durch Drehung in eine Schaltstellung gebracht werden muß, in der ein Eingangskreis des Multimeters vorgewählt wird, der zur Aufnahme der nunmehr am Pfeil 13 liegenden Meßgröße, in diesem Fall die Meßgröße A, geeignet ist. Ein Einschalten des vorgewählten Eingangskreises wird jedoch erst herbeigeführt, wenn es gelingt, das Dreh-Druckelement 9a durch Druck in seine Einschaltstellung zu bringen. Dies ist jedoch nur erreichbar, wenn ein mit dem Dreh-Druckelement 9a verbundenes scheibenartiges Kopplungselement 9b, das mit einem exzentrisch an ihm befestigten ersten Arretierelement 9c versehen ist, in ein zweites als Arretiernut ausgebildetes Arretierelement 10c des Schalterelements 10 eingreifen kann.

Durch die exzentrische Anordnung des als Arretierzapfen ausgebildeten ersten Arretierelementes 9c ändert sich dessen Lage zum Schalterelement 10 des Meßbereichsschalters S mit jeder Drehung des Drehdruckelementes 9a zum Einstellen einer anderen Meßgröße A bis C. Die als zweites Arretierelement 10c im Schalterelement 10 des Meßbereichsschalters ausgebildeten Arretiernuten sind nun jeweils so positioniert, daß der Arretierzapfen 9c nur dann in sie eindringen kann, wenn beide Schalter auf die gleiche Meßgröße A bis C gestellt wurden.

Da die Arretierung lediglich ein Umschalten des Meßbereichsschalters zwischen den verschiedenen Meßgrößen A bis C bei eingeschaltetem Eingangskreisschalter 9 verhindern soll, ist innerhalb des Arretierungsbereichs 10a einer Meßgröße ein Umschalten zwischen verschiedenen Meßbereichen dieser Meßgröße möglich.

Der beschriebene Aufbau mit zwei getrennten Schaltern hat den Vorteil, daß die gegebenenfalls großen Ströme in bestimmten Eingangskreisen nicht mit Hilfe des Meßbereichsschalters geschaltet werden müssen. Es ist einfacher einen mit relativ wenigen Kontakten versehenen Eingangskreisschalter so zu gestalten, daß er auch große Ströme beherrscht. Darüberhinaus ist eine Gefährdung des Eingangskreisschalters beim Umschalten nicht möglich, da vor dem Umschalten immer erst der Stromkreis unterbrochen wird. Weiterhin ist der Benutzer zu erhöhter Aufmerksamkeit gezwungen, wenn er jeweils zwei Schalter in die richtige Stellung bringen muß und er müßte bei der Einstellung der Schalter mindestens zwei Fehler machen, nämlich bei beiden Schaltern die gleiche falsche Meßgröße einstellen, bevor es zu einem Fehlerfall kommt.

Das weitere Beispiel zum Aufbau einer Schutzvorrichtung nach Figur 2 zeigt eine elektrische Schaltung, bei der die Schutzfunktion weitgehend durch elektrische bzw. elektromechanische Bauelemente erreicht wird. Die zur Arretierung des Meßbereichsschalters benötigten mechanischen Bauelemente können, soweit es die Codierung der verschiedenen Meßbereiche betrifft, dem in Fig. 4 dargestellten Prinzip entsprechen.

Das Multimeter nach Figur 2 besitzt zwei Eingangskreise a,b mit den für beide gemeinsamen Eingangsanschlüsse 1 und 2. Der unterschiedliche Aufbau der Eingangskreise a, b soll durch das Meßbereichsnetzwerk N verdeutlicht werden, das z.B. aus Spannungsteilerwiderständen zur Spannungsumschaltung oder Shunts zur Stromumschaltung bestehen kann, und bei dem die Umschaltung durch einen Meßbereichsschalter S erfolgt. Das entsprechend angepaßte Meßsignal gelangt anschließend zu einem Meßsystem Z, das zur Messung und Anzeige dient.

Um das Meßsignal je nach Art der zu erfassenden Meßgröße A, B dem richtigen Meßkreis a, b zuordnen zu können, ist ein Eingangskreisschalter 8 in die Schaltung eingefügt, der ausgehend von einer Nullstellung 0 auf eine Meßgröße A oder B und damit auf die Eingangskreise a,b umgeschaltet werden kann.

Ein zum Eingangskreisschalter 8 gehöriger oder mit diesem mechanisch gekoppelter Hilfskreisschalter HS5 wird ebenfalls ausgehend von einer Nullstellung 0 auf eine der Meßgröße A oder B zugeordnete Schaltstellung umgeschaltet. Zusammen mit einem in Reihe geschalteten Magnetsteller M7, einer Spannungsquelle U und einer Schaltstrecke S1 des Meßbereichschalters S liegt er in einem Hilfskreis H5.

Der Meßbereichsschalter S erlaubt ein Umschalten zwischen den Meßgrößen A und B einerseits sowie zwischen verschiedenen Meßbereichen A1,A2,A3 der Meßgröße A und B1,B2 der Meßgröße B. Die von der Stellung des Meßbereichsschalters S abhängige Stellung der Schaltstrecke S1 ist mit dem Hilfskreisschalter HS5 so verbunden, daß der Magnetsteller M7 und die von ihm abhängige Arretierung Ar3 aktiviert wird, sobald der Hilfskreisschalter S5 auf eine andere Meßgröße geschaltet wird als die durch den Meßbereichsschalter S vorgegebene Meßgröße. Der Hilfskreisschalter HS5 ist dabei so ausgelegt, daß er bei dem Schaltvorgang dem Eingangskreisschalter 8 vorauseilt und beim Umschalten auf eine falsche Meßgröße die Arretierung Ar3 noch in einer Weise wirksam wird, daß sie ein Umschalten des Eingangskreisschalters auf eine falsche Meßgröße verhindert.

Bei den in Fig. 2 dargestellten Schaltstellungen stimmt die am Meßbereichsschalter S eingestellte Meßgröße A mit der am Eingangskreisschalter 8 eingestellten Meßgröße überein. Sollte jedoch versucht werden, den Eingangskreisschalter 8 auf die Meßgröße B umzuschalten, so würde über den voreilenden Hilfskreisschalter HS 5 der Magnetsteller M3 und damit die Arretierung Ar3 in einer Weise aktiviert, daß der Eingangskreisschalter 8 wieder in die Nullstellung N zurückgeschaltet werden müßte.

Die beschriebene Wirkungsweise der Schaltung gewährleistet, daß nach Vorgabe einer Meßgröße durch den Meßbereichsschalter S, nur der Eingangskreis a,b eingeschaltet werden kann, dem die gleiche Meßgröße zugeordnet ist. Darüberhinaus soll jedoch sichergestellt sein, daß bei eingeschaltetem Eingangskreisschalter 8 und damit geschlossenem Eingangskreis a oder b der Meßbereichsschalter S nicht auf eine andere Meßgröße umgeschaltet werden kann. Dies läßt sich mit Hilfe einer zweiten Schaltstrecke des Hilfskreisschalters HS5 erreichen, die in gleicher Weise, wie seine erste Schaltstrecke eine Nullstellung 0 besitzt, von der ausgehend auf eine der Meßgrößen A,B geschaltet werden kann. Über diese zweite Schaltstrecke wird ein weiterer Magnetsteller M5 mit Hilfe der Spannungsquelle U des Hilfskreises H5 gesteuert. Durch die Arretierung Ar4 sorgt er dafür, daß der Meßbereichsschalter S nur umgeschaltet werden kann, wenn sich der Eingangskreisschalter 8 in Nullstellung 0 befindet. Dem Benutzer des Multimeter ist es somit nicht möglich, aus Versehen bei eingeschaltetem Eingangskreisschalter den Meßbereichsschalter S auf eine andere Meßgröße umzuschalten.

Trotz der getroffenen Maßnahmen zur Erhöhung der Bedienungssicherheit des Multimeters verbleibt die Möglichkeit, daß vor Inbetriebnahme des Multimeters bereits eine Meßgröße eingestellt wurde, die für das zu messende Meßsignal ungeeignet ist. Um den Benutzer vor dem Anschließen eines neuen Meßobjektes zur Überprüfung der Multimetereinstellung zu zwingen, ist ein weiterer Magnetsteller M6 vorgesehen, der mit Hilfe eines Verstärkers V das Meßsignal Uₑ überwacht, und bei dessen Wegfall eine Rückstellung des Eingangskreisschalters 8 in seine Nullstellung 0 bewirkt.

Es bedarf keiner näheren Erläuterung, daß der Eingangskreisschalter 3, 4 nach Figur 1 durch einen Eingangskreisschalter, wie er in den Figuren 2 bis 6 dargestellt ist, einschließlich den dafür vorgesehenen Kopplungselementen zur Verbindung mit dem Meßbereichsschalter S, ersetzt werden kann. Von der Prüfschaltung PRS erfaßte, für den vorgesehenen Eingangskreis gefährliche Meßsignale müßten in diesem Fall zu einer Sperrung des Eingangskreisschalters führen, so daß er den Eingangskreis nicht einschalten kann. Hierzu könnte ein elektromechanisch betätigtes Sperrelement dienen, das nur bei Vorliegen eines Freigabesignals den Eingangskreisschalter freigibt.

Das Zurückstellen des Eingangskreisschalters 9 für eine kombinierte Dreh-Druckbetätigung kann in gleicher Weise erfolgen wie bei üblichen Druckschaltern, die bei einem erneuten Betätigungsdruck aus ihrer Verrastung in der Einschaltstellung befreit werden.

## Patentansprüche

1. Meßverfahren für ein zum Messen unterschiedlicher Meßgrößen (A,B) geeignetes Multimeter, bei dem eine Vorgabe der zu untersuchenden Meßgröße (A,B) über einen Meßbereichsschalter (S) und/oder die Auswahl zwischen verschiedenen, jeweils einer bestimmten Meßgröße (A,B) zugeordneten Eingangsanschlüssen (2a,2b) erfolgt und ein für jede Meßgröße (A,B) spezifischer Eingangskreis (a,b) zur Messung vorgesehen ist, dadurch gekennzeichnet,
- daß bei mindestens einer Meßgröße (A, B) vor der eigentlich durchzuführenden Hauptmessung eine Vorprüfung erfolgt, bei der geprüft wird, ob der durch die Stellung des Meßbereichsschalters (S) und/oder die getroffene Auswahl der Eingangsanschlüsse (1, 2) vorgesehene Eingangskreis (a, b) zur Aufnahme des angelegten Meßsignals (Ue) geeignet ist,
- eine Freigabe des vorgesehenen Eingangskreises (a, b) zur Aufnahme des Meßsignals (Ue) nur erfolgt, wenn die Vorprüfung ergeben hat, daß es sich um ein für diesen Eingangskreis (a, b) geeignetes Meßsignal (Ue) handelt,
- ein Fehlersignal abgegeben wird, wenn ein für den vorgegebenen Eingangskreis (a, b) ungeeignetes Meßsignal (Ue) erfolgt.

2. Meßverfahren nach Anspruch 1, dadurch gekennzeichnet, daß
- bei Beginn einer Messung unabhängig von der vorgegebenen Meßgröße (A,B) ein zur Spannungsmessung dienender Eingangskreis mit dem Meßobjekt (Q) verbunden wird,
- das Meßobjekt (Q) zunächst mindestens einer Spannungsmessung unterworfen wird,
- entsprechend der Art der vorgegebenen Meßgröße (A,B) das Ergebnis einer oder mehrerer Spannungsmessungen als Entscheidungskriterium dafür dient, ob der der Meßgröße (A,B) zugeordnete Eingangskreis (a,b) dazu geeignet ist, das vom Meßobjekt (Q) kommende Meßsignal (Ue) aufzunehmen,
- vom Multimeter ein Fehlersignal erzeugt wird, wenn das Meßobjekt (Q) ein Meßsignal (Ue) abgibt, das mit dem vorgegebenen Eingangskreis (a,b) nicht gemessen werden kann oder sollte,
- bei Fehlen eines Fehlersignals und/oder Abgabe eines Freigabesignals ein der Meßgröße (A,B) zugeordneter Eingangskreis (a,b) eingeschaltet wird oder werden kann und sich eine Messung der zu untersuchenden Meßgröße (A,B) anschließt.

3. Meßverfahren nach einem der vorhergehenden Ansprüche, dadurch gekennzeichnet, daß die der eigentlichen Messung vorgeschaltete Prüfung des Meßsignals bezüglich seiner Eignung zur Aufnahme durch den vorgegebenen Eingangskreis auf solche Eingangskreise beschränkt ist, die einer Gefährdung ausgesetzt sind, also vorzugsweise Eingangskreise für Strom- und Widerstandsmessungen.

4. Meßverfahren nach einem der vorhergehenden Ansprüche, dadurch gekennzeichnet, daß die vorgegebene Meßgröße (A,B) ein Widerstand ist, und eine Freigabe des Eingangskreises zur Widerstandsmessung erfolgt, wenn bei der vorausgehenden Spannungsmessung keine Spannung ermittelt wurde, die zu einer Verfälschung des Meßergebnisses oder einer Gefährdung des Meßkreises (a,b) führen kann.

5. Meßverfahren nach einem der vorhergehenden Ansprüche, dadurch gekennzeichnet, daß die vorgegebene Meßgröße (A,B) ein Strom ist und mindestens zwei Spannungsmessungen bei unterschiedlicher Belastung des angeschlossenen, Spannung abgebenden Meßobjektes (Q) durchgeführt werden und mit Hilfe des Spannungsabsenkungsverfahrens zumindest überschlägig der Innenwiderstand (Ri) des Meßobjektes (Q) ermittelt wird und eine Freigabe des Eingangskreises (a,b) zur Strommessung erfolgt, wenn der aus Innenwiderstand (Ri) und Leerlaufspannnung (Uo) des Meßobjektes ermittelte Kurzschlußstrom (Ik) den eingestellten oder größten Strommeßbereich nicht überschreitet.

6. Meßverfahren nach einem der vorhergehenden Ansprüche, dadurch gekennzeichnet, daß bei einem externen Abtrennen des Meßobjektes (Q) der daraus resultierende Wegfall des Meßsignals (Ue) und/oder das plötzliche Ansteigen des Eingangswiderstandes eine Rückschaltung auf den Eingangskreis (a,b) zur Spannungsmessung bewirkt oder durch Auslösen eines Warnsignals veranlaßt wird.

7. Meßverfahren nach Anspruch 6, dadurch gekennzeichnet, daß die Rückschaltung ggf. für eine begrenzte Zeit, vorzugsweise durch einen Tastschalter, außer Kraft gesetzt werden kann.

8. Multimeter zur Durchführung des Verfahrens nach einem der vorhergehenden Ansprüche, bei dem die Vorgabe der Meßgröße (A,B) eines aufzunehmenden Meßsignals (Ue) durch einen Meßbereichsschalter (S) und/oder verschiedene Eingangsanschlüsse (2a,2b) erfolgt und den verschiedenen Meßgrößen (A,B) unterschiedliche Eingangskreise (a,b) zugeordnet sind, dadurch gekennzeichnet, daß mindestens ein Eingangskreisschalter (3,4;8) zum Ein- oder Umschalten von Eingangskreisen (a,b) vorgesehen ist und daß Mittel (PRS ;V) zur Durchführung einer Vorprüfung des Meßsignals (Ue) vorgesehen sind, die zunächst nach entsprechenden Kriterien prüfen, ob ein vorgegebener Eingangskreis (a,b) zur Aufnahme des vom Meßobjekt (Q) abgenommenen Meßsignals geeignet ist und daß diese Mittel (PRS;V) den vorgegebenen Eingangskreis (a,b) zur eigentlichen Messung nur freigeben, wenn es sich um einen geeigneten Eingangskreis (a,b) handelt.

9. Multimeter nach Anspruch 8, dadurch gekennzeichnet, daß die Vorprüfung des Meßsignals mit demselben Meßsystem (Z) erfolgt, das zur eigentlichen Hauptmessung dient und der Eingangskreisschalter (3, 4, 8) so beschaffen ist, daß er bei einem Wechsel von der Vorprüfung zur Hauptmessung verschiedene Eingangskreise (a, b) an das Meßsystem (Z) anschließen kann.

10. Multimeter nach Anspruch 8, dadurch gekennzeichnet, daß die Vorprüfung des Meßsignals mit einem eigenen Prüfsystem (V) erfolgt, das das Meßsignal (Ue) unmittelbar hinter den Eingangsanschlüssen (1, 2) abnimmt und mit diesem unabhängig vom jeweils eingeschalteten Eingangskreis (a, b) immer verbunden bleibt.

11. Multimeter nach einem der Ansprüche 8 bis 10, dadurch gekennzeichnet, daß die Anordnung zur Prüfung des Meßsignals (Ue) so aufgebaut ist, daß zunächst überprüft wird, ob die durch den Meßbereichsschalter (S) vorgegebene Meßgröße zu dem durch die Eingangsanschlüsse (1, 2) oder einen Eingangskreisschalter (3, 4, 8) vorgegebenen Eingangskreis paßt und bei vorliegender Übereinstimmung überprüft wird, ob der vorgesehene Eingangskreis zur Aufnahme des anliegenden Meßsignals (Ue) geeignet ist und erst dann eine Freigabe des Eingangskreises für das anliegende Meßsignal erfolgt.

12. Multimeter nach einem der Ansprüche 8 bis 10, dadurch gekennzeichnet, daß mit dem Meßbereichsschalter (S) eine elektrisch und/oder mechanisch wirkende Sperrvorrichtung (45; 9, 10) gekoppelt ist, die eine Kontaktierung nur jeweils des Eingangskreises ermöglicht, dessen Meßgröße der mit dem Meßbereichsschalter (S) eingestellten Meßgröße (A, B) entspricht und die Vorprüfung sich darauf beschränkt zu überprüfen, ob der vorgesehene Eingangskreis zur Aufnahme des anliegenden Meßsignals geeignet ist.

13. Multimeter nach einem der Ansprüche 8 bis 12, dadurch gekennzeichnet, daß die Steuerung des Eingangskreisschalters (3, 4) durch eine Eingangskreissteuereinheit (EKS), ggf. über Magnetsteller (M1, M2) erfolgt und diese wiederum in Abhängigkeit von einer Steuerschaltung (STS) aktiviert werden, die den Aktivierungsbefehl entsprechend dem Ergebnis der Prüfung des richtigen Eingangskreises und/oder der Prüfung des Meßsignals durch eine Prüfschaltung (PRS) erteilt.

14. Multimeter nach einem der Ansprüche 8 bis 13, dadurch gekennzeichnet, daß das Fehlersignal, das bei einem für den vorgesehenen Eingangskreis nicht geeigneten Meßsignal erzeugt wird, für den Bediener erkennbar gemacht ist und diesen zum Umschalten des Eingangskreises, vorzugsweise über einen mechanisch betätigbaren Eingangskreisschalter veranlaßt oder eine automatische Umschaltung des Eingangskreisschalters auf einen geeigneten Eingangskreis bewirkt.

15. Multimeter nach einem der vorhergehenden Ansprüche 13 und 14, dadurch gekennzeichnet, daß mindestens ein Lastwiderstand vorgesehen ist, der zur Ermittlung des Innenwiderstandes des Meßobjektes (Q), bei bestimmten Meßgrößen (A,B), vorzugsweise bei einer Strommessung, den zugehörigen Eingangskreis mit einem in Reihe liegenden Lastkreisschalter (5) überbrückt und der Lastkreisschalter (5) durch die Steuerschaltung (STS), gegebenenfalls über einen Magnetsteller (M3) so gesteuert wird, daß die Prüfschaltung (PRS) den Innenwiderstand (Ri) nach der Methode der Spannungsabsenkung ermitteln kann.

16. Multimeter nach einem der vorhergehenden Ansprüche 13 bis 15, dadurch gekennzeichnet, daß die Steuerschaltung (STS) den Meßbereichsschalter (S), gegebenenfalls über einen Magnetsteller (M4), gegen Umschalten auf eine andere Meßgröße arretiert, solange ein vom Meßobjekt (Q) ausgehendes Meßsignal (Ue) von der Prüfschaltung (PRS) erfaßt wird.

17. Multimeter nach einem der vorhergehenden Ansprüche 13 bis 16, dadurch gekennzeichnet, daß die Steuerschaltung (STS) mit Hilfe eines oder mehrerer Mikroprozessoren aufgebaut ist, die gegebenenfalls weitere Steuer- und Rechenfunktionen anderer Art wahrnehmen und vorzugsweise auch die Aufgaben der Prüfschaltung (PRS) und der Eingangskreissteuereinheit (EKS) erfüllen, und durch einen Handsteller (H) eine Programmierung oder Eingabe bestimmter Anweisungen erfolgen kann.

18. Multimeter nach einem der vorhergehenden Ansprüche 8 bis 17, dadurch gekennzeichnet, daß der Eingangskreisschalter (3, 4, 8) je nach Schaltungsaufbau als Ein- oder Umschalter, entsprechend der Zahl der Eingangskreise (a, b) ggf. auch mehrpolig ausgeführt ist und von Hand als auch automatisch, vorzugsweise durch Magnetschalter (M1, M2, M6), betätigbar ist.

## Claims

1. Measuring method for a multimeter which is suitable for measuring different measurement variables (A,B), in which a value of the measurement variable (A,B) to be investigated is prescribed by means of a measurement range switch (S) and/or the selection between various input terminals (2a,2b) which are assigned to a specific measurement variable (A,B) in each case, and a specific input circuit (a,b) for each measurement variable (A,B) is provided for the measurement, characterized,
- in that a preliminary testing is carried out at at least one measurement variable (A, B) before the actual main measurement to be performed, during which preliminary testing it is tested whether the input circuit (a, b) which is provided by means of the position of the measurement range switch (S) and/or the selection of the input terminals (1, 2) which has been made is suitable for receiving the applied measurement signal (Ue),
- the input circuit (a, b) provided is enabled to receive the measurement signal (Ue) only if the result of the preliminary test has been that it is a measurement signal (Ue) which is suitable for this input circuit (a, b),
- a fault signal is emitted if a measurement signal (Ue) which is unsuitable for the prescribed input circuit (a, b) occurs.

2. Measuring method according to Claim 1, characterized in that
- at the start of a measurement, an input circuit which serves to measure voltages is connected to the test object (Q) independently of the prescribed measurement variable (A,B),
- the test object (Q) is initially subjected to at least one voltage measurement,
- in accordance with the type of measurement variable (A,B) prescribed, the result of one or more voltage measurements serves as a decision criterion as to whether the input circuit (a,b) which is assigned to the measurement variable (A,B) is suitable for receiving the measurement signal (Ue) coming from the test object (Q),
- a fault signal is produced by the multimeter if the test object (Q) emits a measurement signal (Ue) which cannot, or should not, be measured with the prescribed input circuit (a,b),
- when a fault signal does not occur and/or an enabling signal is emitted, an input circuit (a,b) which is assigned to the measurement variable (A,B) is switched on, or can be switched on, and is followed by a measurement of the measurement variable (A,B) to be investigated.

3. Measuring method according to one of the preceding claims, characterized in that the testing, which precedes the actual measurement, of the measurement signal with respect to its suitability for reception by the prescribed input circuit is restricted to those input circuits which are subjected to risk, that is to say preferably input circuits for measuring currents- and resistances.

4. Measuring method according to one of the preceding claims, characterized in that the prescribed measurement variable (A,B) is a resistance, and the input circuit is enabled to measure resistances if no voltage which can lead to a falsification of the measurement result or to the measurement circuit (a,b) being put at risk has been detected during the preceding voltage measurement.

5. Measuring method according to one of the preceding claims, characterized in that the prescribed measurement variable (A,B) is a current, and at least two voltage measurements are carried out with different loading of the connected test object (Q) which emits voltage, and the internal resistance (Ri) of the test object (Q) is determined, at least approximately, with the aid of the voltage-reduction method, and the input circuit (a,b) is enabled to measure currents if the short-circuit current (Ik) which is determined from the internal resistance (Ri) and the idling voltage (Uo) of the test object does not exceed the set current measurement range or maximum current measurement range.

6. Measuring method according to one of the preceding claims, characterized in that, if the test object (Q) is disconnected externally, the resulting elimination of the measurement signal (Ue) and/or the sudden rise in the input resistance brings about a resetting to the input circuit (a,b) for measuring voltages or is induced by the triggering of a warning signal.

7. Measuring method according to Claim 6, characterized in that the resetting can be deactivated, if appropriate for a limited time, preferably by means of a momentary-contact switch.

8. Multimeter for performing the method according to one of the preceding claims, in which the value of a measurement variable (A,B) of a measurement signal (Ue) to be received is prescribed by a measurement range switch (S) and/or various input terminals (2a,2b), and different input circuits (a,b) are assigned to the various measurement variables (A,B), characterized in that at least one input circuit switch (3,4;8) is provided for switching input circuits (a,b) on or over, and in that means (PRS;V) for performing preliminary testing of the measurement signal (Ue) are provided, which means initially test, according to corresponding criteria, whether a prescribed input circuit (a,b) is suitable for receiving the measurement signal picked off from the test object (Q), and in that these means (PRS;V) enable the prescribed input circuit (a,b) to perform the actual measurement only if it is a suitable input circuit (a,b).

9. Multimeter according to Claim 8, characterized in that the preliminary testing of the measurement signal is carried out with the same measurement system (Z) which is used for the actual main measurement, and the input circuit switch (3, 4, 8) is designed in such a way that it can connect various input circuits (a, b) to the measurement system (Z) when changing over from the preliminary testing to the main measurement.

10. Multimeter according to Claim 8, characterized in that the preliminary testing of the measurement signal is carried out with a dedicated test system (V) which picks off the measurement signal (Ue) directly downstream of the input terminals (1, 2) and always remains connected thereto independently of the respectively switched-on input circuit (a, b).

11. Multimeter according to one of Claims 8 to 10, characterized in that the arrangement for testing the measurement signal (Ue) is designed in such a way that it is initially checked whether the measurement variable prescribed by the measurement range switch (S) matches the input circuit prescribed by the input terminals (1, 2) or by an input circuit switch (3, 4, 8), and, in the case of correspondence, it is checked whether the input circuit provided is suitable for receiving the measurement signal (Ue) present, and only then is the input circuit enabled for the applied measurement signal.

12. Multimeter according to one of Claims 8 to 10, characterized in that an electrically and/or mechanically acting inhibiting device (45; 9, 10) is coupled to the measurement range switch (S) and permits contact to be made in each case only with that input circuit whose measurement variable corresponds to the measurement variable (A, B) set with the measurement range switch (S), and the preliminary testing is restricted to checking whether the input circuit provided is suitable for receiving the measurement signal present.

13. Multimeter according to one of Claims 8 to 12, characterized in that the input circuit switch (3, 4) is controlled by means of an input circuit control unit (EKS), if appropriate by means of magnetic actuators (M1, M2), and the latter are in turn activated as a function of a control circuit (STS) which issues the activation instruction in accordance with the result of the testing of the correct input circuit and/or the testing of the measurement signal by means of a test circuit (PRS).

14. Multimeter according to one of Claims 8 to 13, characterized in that the fault signal which is produced when there is a measurement signal which is not suitable for the input circuit provided is indicated to the operator and induces the operator to switch over the input circuit, preferably by means of a mechanically actuable input circuit switch, or else the fault signal brings about automatic switching over of the input circuit switch to a suitable input circuit.

15. Multimeter according to one of the preceding Claims 13 and 14, characterized in that at least one load resistor is provided which, in order to determine the internal resistance of the test object (Q), in the case of specific measurement variables (A,B), preferably when measuring currents, bridges the associated input circuit with a load circuit switch (5) connected in series, and the load circuit switch (5) is controlled by the control circuit (STS), if appropriate by means of a magnetic actuator (M3), in such a way that the test circuit (PRS) can determine the internal resistance (Ri) according to the method of voltage reduction.

16. Multimeter according to one of the preceding Claims 13 to 15, characterized in that the control circuit (STS) locks the measurement range switch (S), if appropriate by means of a magnetic actuator (M4), against switching over to another measurement variable, as long as a measurement signal (Ue) originating from the test object (Q) is detected by the test circuit (PRS).

17. Multimeter according to one of the preceding Claims 13 to 16, characterized in that the control circuit (STS) is designed using one or more microprocessors which, if appropriate, fulfil further controlling and computing functions of other kinds and preferably also fulfil the functions of the test circuit (PRS) and of the input circuit control unit (EKS), and programming or inputting of specific instructions can be effected by means of a manual regulator (H).

18. Multimeter according to one of the preceding Claims 8 to 17, characterized in that the input circuit switch (3, 4, 8) is realized, depending on the circuitry design, as an on-off switch or change-over switch in accordance with the number of input circuits (a, b) and, if appropriate is also of multi-pole design and can be actuated manually and automatically, preferably by means of magnetic switches (M1, M2, M6).

## Revendications

1. Procédé de mesure pour un multimètre conçu pour mesurer différentes grandeurs (A, B), dans lequel la grandeur à mesurer (A, B) est présélectionnée à l'aide d'un sélecteur (S) de calibre de mesure et/ou une borne d'entrée est sélectionnée parmi différentes bornes (2a, 2b) associées chacune à une grandcur à mesurer (A, B) et dans lequel il est prévu un circuit d'entrée (a, b) spécifique pour chaque grandeur à mesurer (A, B), caractérisé
- en ce que, pour au moins une grandeur à mesurer (A, B), un contrôle préalable, au cours duquel on vérifie si le circuit d'entrée (a, b) prévu par la position du sélecteur de calibre (S) et/ou la sélection retenue des bornes d'entrée (1, 2) sont adaptés pour recevoir le signal de mesure (Ue) en attente, a lieu avant la mesure principale réaliser,
- en ce que le circuit d'entrée (a, b) prévu pour la réception du signal de mesure (Ue) n'est libéré que si le contrôle préalable a montré qu'il s'agit d'un signal de mesure (Ue) convenant audit circuit d'entrée (a, b),
- en ce qu'un signal d'erreur est délivré lorsqu'un signal de mesure (Ue) n'est pas adapté au circuit d'entrée (a, b) présélectionné.

2. Procédé de mesure selon la revendication 1, caractérisé
- en ce qu'au début d'une mesure, un circuit d'entrée servant à la mesure de la tension est connecté à l'objet à mesurer (Q), indépendamment de la grandeur (A, B) à mesurer présélectionnée,
- en ce que l'objet à mesurer (Q) es soumis tout d'abord à au moins une mesure de tension,
- en ce que selon le type de la grandeur à mesurer (A, B) présélectionnée, le résultat d'une ou de plusieurs mesures de tension est utilisé comme critère pour décider si le circuit d'entrée (a, b) associé à la grandeur à mesurer (A, B ) est adapté pour recevoir le signal de mesure (Uc) provenant de l'objet à mesurer (Q),
- en ce qu'un signal d'erreur est généré par le multimètre lorsque l'objet à mesurer (Q) fournit un signal de mesure (Ue) qui ne peut pas ou ne devrait pas être mesuré avec le circuit d'entrée (a, b) présélectionné,
- en l'absence d'un signal d'erreur et/ou lors de la délivrance d'un signal de libération, un circuit d'entrée (a, b) associé à la grandeur à mesurer (A, B) cst ou peut être fermé et une mesure de la grandeur à mesurer (A, B) a lieu.

3. Procédé selon l'une des revendications précédentes, caractérisé en ce que le contrôle du signal de mesure visant à vérifier que celui-ci peut être reçu par le circuit d'entrée présélectionné, prévu avant la mesure à proprement parler, est limité aux circuits d'entrée qui sont exposés à un risque de détérioration, c'est-à-aire de préférence aux circuits d'entrée pour la mesure des intensités et des résistances.

4. Procédé selon l'une des revendications précédentes, caractérisé en ce que la grandeur à mesurer (A, B) présélectionnée est une résistance et que le circuit d'entrée pour la mesure de la résistance est libéré si aucune tension pouvant fausser le résultat de la mesure ou entraîner un risque pour le circuit de mesure (a, b) n'a été détectée lors de la mesure de tension préalable.

5. Procédé selon l'une des revendications précédentes, caractérisé en ce que la grandeur à mesurer (A, B) présélectionnée est un courant, qu'au moins deux mesures de tension sont réalisées avec des charges différentes de l'objet à mesurer (Q) connecté, délivrant une tension, que la résistance interne (Ri) de l'objet à mesurer (Q) est déterminée au moins de façon sommaire par la méthode de la chute de tension et que le circuit d'entrée (a, b) est libéré pour la mesure du courant lorsque le courant de court-circuit (Ik) calculé à partir de la résistance interne (Ri) et de la tension à vide (Uo) de l'objet à mesurer (Q) n'est pas supérieur à la plage d'intensité sélectionnée ou à la plage d'intensité maximale.

6. Procédé selon l'une des revendications précédentes, caractérisé en ce que, en cas de coupure externe de l'objet à mesurer (Q), la disparition du signal de mesure (Ue) et/ou l'augmentation brutale de la résistance d'entrée provoque une commutation sur le circuit d'entrée (a, b) pour la mesure de la tension ou le déclenchement d'un signal d'alerte.

7. Procédé selon l'une des revendications précédentes caractérisé en ce que la commutation peut être annulée, le cas échéant pour une durée limitée, à l'aide d'un bouton poussoir.

8. Multimètre pour la mise en oeuvre du procédé selon l'une des revendications précédentes dans lequel la grandeur à mesurer (A, B) d'un signal de mesure (Ue) est présélectionnée à l'aide d'un sélecteur de calibre (S) et/ou de différentes bornes d'entrées (2a, 2b) et des circuits d'entrée (a, b) différents sont associés aux différentes grandeurs à mesurer (A, B), caractérisé en ce qu'il est prévu au moins un contact de circuit d'entrée (3, 4; 8) pour la fermeture ou la commutation de circuits d'entrée (a, b), en ce que des moyens (PRS; V) pour effectuer un contrôle préalable du signal de mesure (Ue) sont prévus, lesquels moyens contrôlent tout d'abord suivant des critères adaptés si un circuit d'entrée (a, b) présélectionné est adapté pour recevoir le signal en provenance de l'objet à mesurer (Q) et en ce que ces moyens (PRS; V) ne libèrent le circuit d'entrée (a, b) présélectionné pour la mcsure à proprement parler que s'il s'agit d'un circuit d'entrée (a, b) adapté.

9. Multimètre selon la revendication 8, caractérisé en ce que le contrôle préalable du signal de mesure a lieu avec le même système de mesure (Z) que celui servant à la mesure à proprement parler et que le contact de circuit d'entrée (3, 4, 8) est agencé de telle sorte qu'il peut, lors d'un passage du contrôle préalable à la mesure principale, connecter différents circuits d'entrée (a, b) au système de mesure (Z).

10. Multimètre selon la revendication 8, caractérisé en ce que le contrôle préalable du signal de mesure a lieu avec un système de mesure (V) propre qui prélève lc signal de mesure (Ue) immédiatement après les bornes d'entrée (1, 2) et reste connecté de manière permanente à celles-ci, indépendamment du circuit d'entrée (a, b) en service.

11. Multimètre selon l'une des revendications 8 à 10, caractérisé en ce que le dispositif de contrôle du signal de mesure (Ue) est agencé de telle sorte qu'il contrôle tout d'abord si la grandeur à mesurer présélectionnée à l'aide du sélecteur de calibre (S) est adaptée au circuit d'entrée sélectionné à l'aide des bornes d'entrée (1, 2) ou d'un contact de circuit d'entrée (3, 4, 8) et, lorsque l'adaptation est correcte, qu'il contrôle si le circuit d'entrée sélectionné est adapté pour recevoir le signal de mesure (Ue) en attente et ne libère qu'à ce moment le circuit d'entrée pour le signal de mesure en attente.

12. Multimètre selon l'une des revendications 8 à 10, caractérisé en ce qu'un dispositif de blocage (45; 9, 10) à action électrique et/ou mécanique est couplé au sélecteur de calibre (S), lequel dispositif permet d'établir le contact uniquement avec le circuit d'entrée dont la grandeur à mesurer correspond à la grandeur à mesurer (A, B) présélectionnée à l'aide du sélecteur de calibre (S) et que le contrôle préalable se limite à vérifier si le circuit d'entrée sélectionné est adapté pour recevoir le signal de mesure en attente.

13. Multimètre selon l'une des revendications 8 à 12, caractérisé en ce que la commande du contact de circuit d'entrée (3, 4) a lieu à l'aide d'une unité de commande de circuit d'entrée (EKS), le cas échéant par l'intermédiaire d'un actionneur magnétique (M1, M2), et que celle-ci est activée, à son tour, en relation avec un circuit de commande (STS) qui délivre l'ordre d'activation en fonction du résultat du contrôle du bon circuit d'entrée et/ou du contrôle du signal de mesure par un circuit de contrôle (PRS).

14. Multimètre selon l'une des revendications 8 à 13, caractérisé en ce que le signal d'erreur qui est généré en cas de signal de mesure non adapté au circuit d'cntrée sélectionné est rendu identifiable par l'utilisateur et invite celui-ci à commuter le circuit d'entrée, de préférence à l'aide d'un contact de circuit d'entrée actionné mécaniquement ou provoque une commutation automatique du contact de circuit d'entrée sur un circuit d'entrée adapté.

15. Multimètre selon l'une des revendications 13 et 14 précédentes, caractérisé en ce qu'il est prévu au moins une résistance de charge qui, pour déterminer la résistance interne de l'objet à mesurer (Q), pour certaines grandeurs à mesurer (A, B), de préférence pour une mesure du courant, ponte le circuit d'entrée concerné avec un contact de circuit de charge (5) et que le contact de circuit de charge (5) est commandé par le circuit de commande (STS), le cas échéant par l'intermédiaire d'un actionneur magnétique (M3) de telle sorte que le circuit de contrôle (PRS) puisse déterminer la résistance interne (Ri) selon la méthode de la chute de tension.

16. Multimètre selon l'une des revendications 13 à 15 précédentes, caractérisé en ce que le circuit de commande (STS) bloque le sélecteur de calibre de mesure (S), le cas échéant par l'intermédiaire d'un actionneur magnétique (M4), de manière à empêcher toute commutation vers une autre grandeur à mesurer aussi longtemps qu'un signal de mesure (Ue) en provenance de l'objet à mesurer (Q) est détecté.

17. Multimètre selon l'une des revendications 13 à 16 précédentes, caractérisé en ce que le circuit de commande (STS) comprend un ou plusieurs microprocesseurs qui, le cas échéant, assurent des fonctions de commande et dc calcul supplémentaires de nature différente et de préférence remplissent les fonctions du circuit de contrôle (PRS) et de l'unité de commande de circuit d'cntrée (EKS) et qu'une programmation et une entrée de certaines instructions peuvent être réalisées à l'aide d'une commande manuelle (H).

18. Multimètre selon l'une des revendications 8 à 17 précédentes, caractérisé en ce que le contact de circuit d'entrée (3, 4, 8), selon la conception du circuit, est agencé sous forme d'interrupteur ou de commutateur en fonction du nombre de circuits d'entrée (a, b), le cas échéant est multipolaire et peut être actionné manuellement ou de manière automatique, de préférence par un actionneur magnétique (M1, M2, M3).
